# EUROPÄISCHE PATENTSCHRIFT

(11) **EP 2 129 741 B1**
(45) Veröffentlichungstag und Bekanntmachung des Hinweises auf die Patenterteilung: **18.05.2011**
(21) Anmeldenummer: 08716260.8
(22) Anmeldetag: 05.03.2008
(51) Int. Cl.: C09K 11/59

(54) **VERFAHREN ZUR HERSTELLUNG VON LEUCHTSTOFFEN BESTEHEND AUS ORTHOSILIKATEN FÜR pcLEDs**
METHOD FOR PRODUCING PHOSPHORS CONSISTING OF ORTHOSILICATES FOR pcLEDs
PROCÉDÉ DE PRODUCTION DE SUBSTANCES LUMINESCENTES À BASE D'ORTHOSILICATES POUR DIODES ÉLECTROLUMINESCENTES À CONVERTISSEUR PHOSPHORE

(30) Priorität: 04.04.2007 DE 102007016229
(43) Veröffentlichungstag der Anmeldung: 09.12.2009
(73) Patentinhaber: Merck Patent GmbH, 64293 Darmstadt (DE)
(72) Erfinder: WINKLER, Holger, 64291 Darmstadt (DE); VOSGROENE, Tim, 64372 Ober-Ramstadt (DE); ROTH, Gundula, 17498 Lelvenhagen (DE); TEWS, Walter, 17489 Greifswald (DE); TEWS, Stefan, 17489 Greifswald (DE)
(86) Internationale Anmeldenummer: PCT/EP2008/001743
(87) Internationale Veröffentlichungsnummer: WO 2008/122332

(56) Entgegenhaltungen:
- EP-A- 1 715 023
- EP-A- 1 726 630
- KR-A- 20030 060 697
- US-A1- 2004 227 465
- KANG H S ET AL: "Eu-doped barium strontium silicate phosphor particles prepared from spray solution containing NH4Cl flux by spray pyrolysis" MATERIALS SCIENCE AND ENGINEERING B, ELSEVIER SEQUOIA, LAUSANNE, CH, Bd. 121, Nr. 1-2, 25. Juli 2005 (2005-07-25), Seiten 81-85, XP004940745 ISSN: 0921-5107
- JUNG ET AL: "Preparation of CaMgSi2O6:Eu blue phosphor particles by spray pyrolysis and its VUV characteristics" MATERIALS CHEMISTRY AND PHYSICS, ELSEVIER, Bd. 98, Nr. 2-3, 1. August 2006 (2006-08-01), Seiten 330-336, XP005435005 ISSN: 0254-0584

## Beschreibung

Die Erfindung betrifft ein nasschemisches Verfahren zur Herstellung von Leuchtstoffen, die aus mit Europium (II)-dotierten Erdalkaliorthosilikaten bestehen.

Unter dem Color-on-demand Konzept versteht man die Realisierung von Licht eines bestimmten Farbortes mit einer pcLED unter Einsatz eines oder mehrer Leuchtstoffe. Dieses Konzept wird z.B. verwendet, um bestimmte Corporate Designs z.B. für beleuchtete Firmenlogos, Marken etc. zu erzeugen.

In letzter Zeit wurden Leuchtstoffe, die blaugrünes Licht, gelbgrünes bis oranges Licht beruhend auf Anregung in der UV-Lichtregion oder blauen Lichtregion des optischen Spektrums ausstrahlen, immer wichtiger. Dies liegt daran, weil die Leuchtstoffe für ein weißes Licht emittierendes Gerät verwendet werden können. Speziell Cer dotierte Granat-Leuchtstoffe (YAG:Ce) werden in verschiedener Weise verwendet (siehe z.B. EP 862794, WO 98/12757). Diese weisen allerdings den Nachteil auf, dass sie nur bei einem Emissionsmaximum kleiner als 560 nm eine genügend hohe Effizienz besitzen. Aus diesem Grund können mit den reinen YAG:Ce-Leuchtstoffen in Kombination mit blauen Dioden (450-490 nm) nur kaltweiße Lichtfarben mit Farbtemperaturen zwischen 6000 und 8000 K und mit vergleichsweise niedriger Farbwiedergabe (typische Werte für den Farbwiedergabeindex Ra liegen zwischen 70 und 75) realisiert werden. Daraus ergeben sich stark eingeschränkte Anwendungsmöglichkeiten. Zum einen werden bei der Anwendung von Weißlichtquellen in der Allgemeinbeleuchtung in der Regel höhere Anforderungen an die Farbwiedergabequalität der Leuchtmittel gestellt, und zum anderen werden von den Konsumenten vor allem in Europa und in Nordamerika wärmere Lichtfarben mit Farbtemperaturen zwischen 2700 und 5000 K bevorzugt.

Aus der WO 00/33389 ist weiterhin bekannt, u.a. Ba₂SiO₄: Eu²⁺ als Luminophor zur Konvertierung des Lichtes blauer LEDs zu verwenden. Das Maximum der Emission des Leuchtstoffes liegt aber bei 505 nm, so dass mit einer solchen Kombination mit Sicherheit kein weißes Licht erzeugt werden kann.

Silikatleuchtstoffe wurden in den vergangenen Jahren für weiße LEDs entwickelt (siehe WO 02/11214, WO 02/054502). Ferner ist bekannt, dass diese Leuchtstoffe für Gasentladungslampen verwendet werden können (siehe K.H. Butler "Fluorescent Lamp Phosphors" Pennsylvania Univ. Press, 1980). Außerdem beschreibt T.L. Barry, J. Electrochem. Soc. 1968, 1181, dass homogene feste binäre Mischungen von (Ca,Sr)₂SiO₄:Eu systematisch erforscht wurden. Diese Leuchtstoffe wurden nach der Festkörperdiffusions-Methode (mixing & firing-Methode) hergestellt, indem oxidische Edukte als Pulver gemischt, vermahlen und danach in einem Ofen bei Temperaturen bis zu 1500°C bis zu mehreren Tagen in einer ggf. reduzierenden Atmosphäre geglüht werden. Als Resultat entstehen Leuchtstoffpulver, die Inhomogenitäten aufweisen in Bezug auf die Morphologie, die Partikelgrößenverteilung und die Verteilung der lumineszenten Aktivatorionen in dem Volumen der Matrix. Desweiteren sind die Morphologie, die Partikelgrößenverteilungen und weitere Eigenschaften dieser nach dem traditionellen Verfahren hergestellten Leuchtstoffe nur schlecht einstellbar und schwer reproduzierbar. Daher besitzen diese Partikel mehrere Nachteile, wie insbesondere eine inhomogene Beschichtung der LED Chips mit diesen Leuchtstoffen mit nicht optimaler und inhomogener Morphologie sowie Partikelgrößenverteilung, die zu hohen Verlustprozessen durch Streuung führen. Weitere Verluste entstehen in der Produktion dieser LEDs dadurch, dass die Leuchtstoffbeschichtung der LED Chips nicht nur inhomogen, sondern auch von LED zu LED nicht reproduzierbar ist. Dies führt dazu, dass es zu Variationen der Farborte des emittierten Lichtes der pcLEDs auch innerhalb einer Charge kommt.

Die LED-Silikatleuchtstoffe werden einzeln oder in Mischung für eine blaue oder UV LED Matrize verwendet, um einen höheren CRI als die YAG;Ce Serie zu erhalten. In der Praxis zeigen die herkömmlichen Silikatleuchtstoffe jedoch keine höhere Effizienz und Beleuchtungs-stärke als die YAG:Ce Leuchtstoffe. Daneben wird berichtet (siehe T.L. Barry, J. Electrochem. Soc. 1968, 1181), dass einige Leuchtstoffe mit hoher Bariumkonzentration während der Verwendung ein Problem mit der Hydrolyseempfindlichkeit besitzen. Diese Mängel führen zu einer verminderten Effizienz der Silikatleuchtstoffe.

Aus DE 10 2005051063 A1 ist ein silikatbasierter Leuchtstoff mit verbesserter Emissionseffizienz bekannt, der nasschemisch (Nassmahl- und Nasssiebverfahren) unter Verwendung eines nichtwässrigen, organischen Lösungsmittel wie z.B. Ethanol hergestellt wurde, um das meiste Wasser zu entfernen, dass in einem Reinigungsverfahren übrig geblieben ist.

Kang et al. Materials Science and Engineering B, Elsevier Sequoia Lausanne, CH, Bd. 121, Nr. 1-2, 25.7.2005, Seiten 81-85 beschreibt Erdalkali-ortho-silikate, die über eine Spraypyrolyse bei 900°C, ausgehend von Erdalkalinitraten und Europiumoxid als Dotierstoff sowie TEOS und einem Flussmittel Ammoniumchlorid hergestellt werden. Die thermische Nachbehandlung erfolgt bei 1050 °C.

KR20030060697 beschreibt Erdalkali-ortho-silikate, die über eine Spraypyrolyse bei 900°C, ausgehend von Erdalkalinitraten und Europiumoxid als Dotierstoff sowie TEOS hergestellt werden. Anschließend erfolgt eine thermische Nachbehandlung bei 1200°C.

EP1715023 beschreibt ein Verfahren zur Herstellung von o-Silikaten ausgehend von einer wässrigen Mischung aus Barium-, Strontium- und Europiumnitrat und SiO₂, Trocknen der Lösung sowie thermischer Nachbehandlung bei Temperaturen von 1050°C in reduzierter Atmosphäre.

US2004/227465 beschreibt die Herstellung von o-Silikaten ausgehend von Erdalkalicarbonaten über eine Festkörperdiffusionsmethode.

Aufgabe der vorliegenden Erfindung ist es daher ein Verfahren zur Herstellung von Erdalkaliorthosilikat-Leuchtstoffen für weiße LEDs oder für Color-on-demand-Anwendungen zur Verfügung zu stellen, die eines oder mehrere der oben genannten Nachteile nicht aufweisen und warm weißes Licht erzeugen.

Diese Aufgabe wird überraschenderweise dadurch gelöst, dass man die Erdalkaliorthosilikat-Leuchtstoffe nasschemisch herstellt, wobei zwei Verfahrensvarianten möglich sind.

Gegenstand der vorliegenden Erfindung ist somit ein Vefahren zur Herstellung von Leuchtstoffen der Formel 1

Ba_{w}SrₓCaySiO₄ zEu²⁺ (I)

wobei
w+x+y+z=2 und
0,005 < z < 0,5 gilt,
gekennzeichnet dadurch, dass
a) mindestens zwei Erdalkalihydroxide sowie ein Europium-haltiger Dotierstoff in Form von chloriden oder deren Gemische in Wasser, Säuren oder Basen gelöst, suspendiert oder dispergiert werden, und
b) eine Silicium-haltige Verbindung bei einer Temperatur zwischen 75°C und 90°C zugesetzt und
c) dieses Gemisch bei Temperatur < 300°C sprühgetrocknet wird und
d) anschließend durch thermische Nachbehandlung zum fertigen Leuchtstoff umgewandelt wird.

Dabei können w, x, y oder z Werte zwischen 0 und 2 annehmen.

Als Erdalkalimetall-Edukte werden vorzugsweise Barium-, Strontium- und/oder Calciumhydroxid im gewünschten stöchiometrischen Verhältnis eingesetzt.

Als Silicium-haltige Verbindung kommen bei beiden Verfahrensvarianten generell anorganische oder auch organische Silicium-Verbindungen in Betracht. Erfindungsgemäß bevorzugt wird Silicumdioxid oder Tetraethylorthosilikat eingesetzt.

Es wird die Silicium-haltige Verbindung dem Gemisch aus Erdalkali-Salzen und Dotierstoff bei Temperaturen zwischen 75 und 90 °C zugesetzt. Anschließend erfolgt eine Sprühtrocknung in einem Sprühturm der Fa. GEA Niro bei Temperaturen zwischen 200 und 350 °C, vorzugsweise zwischen 250 und 300 °C. Der Düsendruck im Sprühturm liegt zwischen 1 und 3 bar, vorzugsweise bei 2 bar. Die Menge der versprühten Lösung in Abhängigkeit von der Zeit liegt zwischen 2 und 6 Litern Reaktionslösung pro Stunde, vorzugsweise bei 4 Litern pro Stunde.

Als Dotierstoffe werden Europium-chlorid eingesetzt.

Bevorzugt ist es ferner, wenn die Dotierkonzentration des Europiums zwischen 0,5 und 50 Mol % liegt. Besonders bevorzugt liegt sie zwischen 2,0 und 20 Mol %. Bei einer Europium-Konzentration zwischen 10 und 15 Mol % kommt es generell zu einer verstärkten Absorption und dadurch zu einer erhöhten Lichtausbeute bzw. einer größeren Helligkeit des Leuchtstoffes. Eine höhere Europium-Konzentration würde die Quantenausbeute reduzieren und damit wiederum zu einer verringerten Lichtausbeute führen.

Die thermische Nachbehandlung des Leuchtstoffprecursors zum fertigen Leuchtstoff erfolgt in einem Hochtemperaturofen durch mehrstündiges Glühen einer definierten Menge Precursor bei Temperaturen zwischen 1000 und 1400 °C in Korundtiegeln. Der Leuchtstoffrohkuchen wird zerkleinert, gewaschen und gesiebt.

Bei der oben genannten thermischen Nachbehandlung ist es bevorzugt, wenn die Glühung zumindest teilweise unter reduzierenden Bedingungen (z.B. mit Kohlenmonoxid, Formiergas oder Wasserstoff oder zumindest Vakuum oder Sauerstoffmangel-Atmosphäre) durchgeführt wird.

Die Partikelgröße der erfindungsgemäßen Leuchtstoffe beträgt zwischen 50 nm und 50 µm, vorzugsweise zwischen 1 µm und 25 µm.

In einer weiteren Verfahrensvariante ist es erfindungsgemäß bevorzugt, wenn die Oberfläche des Leuchtstoffes zusätzlich strukturiert wird, z.B. durch eine pyramidale Struktur (siehe DE 102006054330.0, Merck, die voll umfänglich in den Kontext der vorliegenden Anmeldung durch Bezugnahme eingefügt wird). Somit kann möglichst viel Licht aus dem Leuchtstoff ausgekoppelt werden.

Die strukturierte Oberfläche auf dem Leuchtstoff wird durch nachträgliches Beschichten mit einem geeigneten Material, welches bereits strukturiert ist, oder in einem nachfolgenden Schritt durch (photo-) lithografische Verfahren, Ätzverfahren oder durch Schreibverfahren mit Energie- oder Materiestrahlen oder Einwirkung von mechanischen Kräften hergestellt.

In einer weiteren Verfahrensvariante ist es erfindungsgemäß bevorzugt, wenn auf der, einem LED Chip entgegengesetzten Seite eine raue Oberfläche erzeugt wird, die Nanopartikel aus SiO₂, TiO₂, Al₂O₃, ZnO₂, ZrO₂ und/oder Y₂O₃ oder Kombinationen aus diesen Materialien oder aus Partikeln mit der Leuchtstoffzusammensetzung trägt.

Dabei hat eine raue Oberfläche eine Rauhigkeit von bis zu einigen 100 nm. Die beschichtete Oberfläche hat den Vorteil, dass Totalreflexion verringert oder verhindert werden kann und das Licht besser aus dem erfindungsgemäßen Leuchtstoff ausgekoppelt werden kann (siehe DE 102006054330.0 (Merck), die voll umfänglich in den Kontext der vorliegenden Anmeldung durch Bezugnahme eingefügt wird.)

Weiterhin bevorzugt ist es, wenn die nach dem erfindungsgemäßen Verfahren hergestellten Leuchtstoffe auf der dem Chip abgewandten Oberfläche eine Brechzahl angepasste Schicht besitzen, welche die Auskopplung der Primärstrahlung und oder der vom Leuchtstoffkörper emittierten Strahlung erleichtert.

In einer weiteren Verfahrensvariante ist es erfindungsgemäß bevorzugt, wenn die Oberfläche des Leuchtstoffes zusätzlich mit einer geschlossenen Beschichtung aus SiO₂, TiO₂, Al₂O_{3,} ZnO, ZrO₂ und/oder Y₂O₃ oder Mischoxide daraus versehen wird. Diese Oberflächenbeschichtung hat den Vorteil, dass durch eine geeignete Abstufung der Brechungsindices der Beschichtungsmaterialien eine Anpassung des Brechungsindex mit der Umgebung erzielt werden kann. In diesem Fall wird die Streuung des Lichtes an der Oberfläche des Leuchtstoffes verringert und ein größerer Anteil des Lichtes kann in den Leuchtstoff eindringen und dort absorbiert und konvertiert werden. Außerdem ermöglicht es die Brechungsindexangepasste Oberflächebeschichtung, dass mehr Licht aus dem Leuchtstoff ausgekoppelt wird, weil die interne Totalreflexion verringert wird.

Zudem ist eine geschlossene Schicht dann vorteilhaft, wenn der Leuchtstoff verkapselt werden muss. Dies kann erforderlich sein, um einer Empfindlichkeit des Leuchtstoffes oder Teilen davon gegen diffundierendes Wasser oder andere Materialien in der unmittelbaren Umgebung zu entgegnen. Ein weiterer Grund für die Verkapselung mit einer geschlossenen Hülle ist eine thermische Entkoppelung des eigentlichen Leuchtstoffes von der Wärme, die im Chip entsteht. Diese Wärme führt zu einer Verringerung der Fluoreszenzlichtausbeute des Leuchtstoffes und kann auch die Farbe des Fluoreszenzlichts beeinflussen. Schliesslich ist es möglich durch eine solche Beschichtung die Effizienz des Leuchtstoffes zu erhöhen, indem im Leuchtstoff entstehende Gitterschwingungen in ihrer Ausbreitung an die Umgebung gehindert werden.

Außerdem bevorzugt ist es, wenn durch das Verfahren Leuchtstoffe mit einer porösen Oberflächenbeschichtung hergestellt werden, die aus SiO₂, TiO₂, Al₂O₃, ZnO, ZrO₂ und/oder Y₂O₃ oder Mischoxide daraus oder aus der Leuchtstoffzusammensetzung besteht. Diese porösen Beschichtungen bieten die Möglichkeit, den Brechungsindex einer Einfachschicht weiter zu reduzieren. Die Herstellung solcher poröser Beschichtungen kann nach drei her-kömmlichen Methoden geschehen, wie sie in WO 03/027015 beschrieben werden, die voll umfänglich in den Kontext der vorliegenden Anmeldung durch Bezugnahme eingefügt wird: das Ätzen von Glas (z.B. Natron-Kalk-Gläser (siehe US 4019884)), das Aufbringen einer porösen Schicht und die Kombination aus poröser Schicht und einem Ätzvorgang.

In einer weiteren bevorzugten Verfahrensvariante werden Leuchtstoffe mit einer Oberfläche hergestellt, die funktionelle Gruppen tragen, welche eine chemische Anbindung an die Umgebung, vorzugsweise bestehend aus Epoxy- oder Silikonharz ermöglichen. Diese funktionellen Gruppen können z.B. über Oxogruppen angebundene Ester oder andere Derivate sein, die mit Bestandteilen der Bindemittel auf Basis von Epoxiden und / oder Silikonen Verknüpfungen eingehen können. Solche Oberflächen haben den Vorteil, dass eine homogene Einmischung der Leuchtstoffe in das Bindemittel ermöglicht wird. Des Weiteren können dadurch die rheologischen Eigenschaften des Systems Leuchtstoff / Bindemittel und auch die Topfzeiten in einem gewissen Masse eingestellt werden. Damit wird die Verarbeitung der Gemische vereinfacht.

Da die auf dem LED Chip aufgebrachte erfindungsgemäße Leuchtstoffschicht vorzugsweise aus einem Gemisch von Silikon und homogenen Leuchtstoffpartikeln besteht, und das Silikon eine Oberflächenspannung aufweist, ist diese Leuchtstoffschicht auf mikroskopischer Ebene nicht einheitlich bzw. ist die Dicke der Schicht nicht durchweg konstant.

Der nach dem erfindungsgemäßen Verfahren hergestellte Leuchtstoff hat eine Zusammensetzung nach Formel I

Ba_{w}SrₓCa_{y}SiO₄: zEu²⁺ (I)

wobei
w+x+y+z=2 und
0,005 < z < 0,5 gilt.

Der Leuchtstoffkann eine strukturierte Oberfläche oder eine raue Oberflächen, be sitzen, die Nanopartikel aus SiO₂, TiO₂, Al₂O₃, ZnO, ZrO₂ und/oder Y₂O₃ oder Mischoxide daraus oder aus Partikel mit der Leuchstoffzusammensetzung trägt.

Weiterhin bevorzugt ist es, wenn dieser Leuchtstoff der Formel I eine geschlossene oder aber poröse Oberflächenbeschichtung besitzt, die aus SiO₂, TiO₂, Al₂O₃, ZnO, ZrO₂ und/oder Y₂O₃ oder Mischoxide daraus besteht.

Ferner kann es bevorzugt sein, wenn die Oberfläche des Leuchtstoffes funktionelle Gruppen trägt, welche eine chemische Anbindung an die Umgebung, vorzugsweise aus Epoxy- oder Silikonharz, ermöglicht.

Mit Hilfe der o.g. Verfahren können beliebige äußere Formen der Leuchtstoffpartikel hergestellt werden, wie sphärische Partikel, Plättchen und strukturierte Materialien und Keramiken.

Die Herstellung von plättchenförmigen Leuchtstoffen als weitere bevorzugte Ausführungsform geschieht nach herkömmlichen Verfahren aus den entsprechenden Erdalkalimetall-Salzen und Europium-Salzen. Das Herstellverfahren ist in EP 763573 und DE 102006054331.9 ausführlich beschrieben, welche voll umfänglich in den Kontext der vorliegenden Anmeldung durch Bezugnahme eingefügt werden. Diese plättchenförmigen Leuchtstoffe können hergestellt werden, indem ein natürlicher oder synthetisch hergestellter hoch stabiler Träger bzw. ein Substrat aus beispielsweise Glimmer-, SiO₂-, Al₂O₃-, ZrO₂, Glas- oder TiO₂-Plättchen, welches ein sehr großes Aspektverhältnis aufweist, eine atomar glatte Oberfläche und eine einstellbare Dicke besitzt, durch Fällungsreaktion in wässriger Dispersion oder Suspension mit einer Leuchtstoffschicht beschichtet werden kann. Neben Glimmer, ZrO₂, SiO₂, Al₂O₃, Glas oder TiO₂ oder Gemischen derselben können die Plättchen auch aus dem Leuchtstoffmaterial selbst bestehen, oder aus einem Material aufgebaut sein. Falls das Plättchen selbst lediglich als Träger für die Leuchtstoffbeschichtung dient, muss diese aus einem Material bestehen, welches transparent für die Primärstrahlung der LED ist, oder die Primärstrahlung absorbiert und diese Energie auf die Leuchtstoffschicht überträgt. Die plättchenförmigen Leuchtstoffe werden in einem Harz (z.B. Silikon- oder Epoxidharz), dispergiert und diese Dispersion wird auf dem LED Chip aufgebracht.

Die plättchenförmigen Leuchtstoffe können in Dicken von 50 nm bis zu etwa 300 µm, vorzugsweise zwischen 150 nm und 100 µm, grosstechnisch hergestellt werden. Der Durchmesser beträgt dabei von 50 nm bis 20 µm. Er besitzt in der Regel ein Aspektverhältnis (Verhältnis des Durchmessers zur Teilchendicke) von 1 : 1 bis 400 : 1, und insbesondere 3 : 1 bis 100 : 1. Die Plättchenausdehnung (Länge x Breite) ist von der Anordnung abhängig. Plättchen eignen sich auch als Streuzentren innerhalb der Konversionsschicht, insbesondere dann, wenn sie besonders kleine Abmessungen aufweisen.

Die dem LED Chip zugewandte Oberfläche des erfindungsgemäßen plättchenförmigen Leuchtstoffes kann mit einer Beschichtung versehen werden, welche entspiegelnd in Bezug auf die von dem LED Chip emittierte Primärstrahlung wirkt. Dies führt zu einer Verringerung der Rückstreuung der Primärstrahlung, wodurch diese besser in den erfindungsgemäßen Leuchtstoffkörper eingekoppelt werden kann.

Hierfür eignen sich beispielsweise brechzahlangepasste Beschichtungen, die eine folgende Dicke d aufweisen müssen: d = [Wellenlänge der Primärstrahlung des LED Chips /(4* Brechzahl der Leuchtstoffkeramik)], s. beispielsweise Gerthsen, Physik, Springer Verlag, 18. Auflage, 1995. Diese Beschichtung kann auch aus photonischen Kristallen bestehen. Wobei hierunter auch eine Strukturierung der Oberfläche des plättchenförmigen Leuchtstoffes fällt, um bestimmte Funktionalitäten zu erreichen. Somit kann möglichst viel Licht aus dem Leuchtstoffkörper ausgekoppelt werden. Die strukturierte Oberfläche auf dem Leuchtstoffkörper wird dadurch hergestellt, in dem beim isostatischen Verpressen das Presswerkzeug eine strukturierte Pressplatte aufweist und dadurch eine Struktur in die Oberfläche prägt. Strukturierte Oberflächen sind dann gewünscht, wenn möglichst dünne Leuchtstoffkörper bzw. Plättchen hergestellt werden sollen. Die Pressbedingungen sind dem Fachmann bekannt (siehe J. Kriegsmann, Technische keramische Werkstoffe, Kap. 4, Deutscher Wirtschaftsdienst, 1998). Wichtig ist, dass als Presstemperaturen 2/3 bis zu 5/6 der Schmelztemperatur des zu verpressenden Stoffes verwendet werden.

Die Anregbarkeit der erfindungsgemäßen Leuchtstoffe erstreckt sich zudem über einen weiten Bereich, der von etwa 120 nm bis 530 nm, bevorzugt 254 nm bis zu etwa 480 nm reicht. Damit sind diese Leuchtstoffe nicht nur zur Anregung durch UV oder blau emittierende primäre Lichtquellen wie LEDs oder konventionelle Entladungslampen (z.B. auf Hg-Basis) geeignet, sondern auch für Lichtquellen wie solche, welche die blaue In³⁺ -Linie bei 451 nm ausnutzen.

Die erfindungsgemäßen Leuchtstoffe können in eine Beleuchtungseinheit mit mindestens einer primären Lichtquelle eingesetz werden, dessen Emissionsmaximum bzw. -maxima im Bereich 120 nm bis 530 nm, bevorzugt 254 nm bis zu etwa 480 nm reicht, wobei die primäre Strahlung teilweise oder vollständig durch die erfindungsgemäßen Leuchtstoffe in längerwellige Strahlung konvertiert wird.

Erfindungsgemäß umfasst der Begriff "Beleuchtungseinheit" folgende Bau- oder Bestandteile:
- mindestens eine primäre Lichtquelle um ultraviolettes oder blaues Licht zu emittieren,
- mindestens einen Konversionsleuchtstoff, der sich im direkten oder indirekten Kontakt mit einer primären Lichtquelle befindet,
- gegebenenfalls ein transparentes Dichtungsharz (z.B. Epoxy- oder Silikonharz) zur Kapselung der Beleuchtungseinheit,
- gegebenenfalls ein Trägerbauteil, auf welchem die primäre Lichtquelle montiert ist und welches mindestens zwei elektrische Anschlüsse zum Zuführen elektrischer Energie für die primäre Lichtquelle besitzt,
- gegebenenfalls Sekundär- optische Anordnungen wie Linsen, Spiegel, Prismen oder photonische Kristalle.

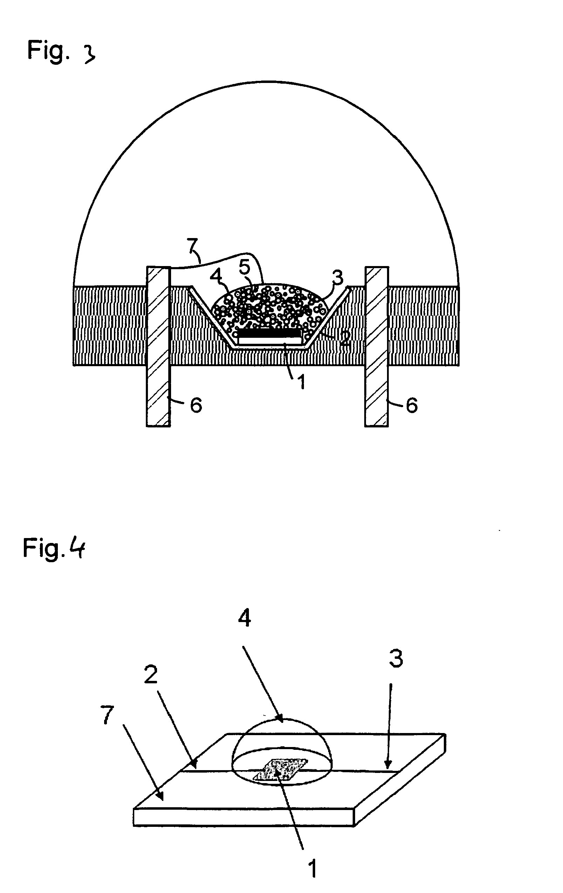

Vorzugsweise ist diese Beleuchtungseinheit weiß emittierend oder emittiert Licht mit einem bestimmten Farbort (Color-on-demand-Prinzip). Bevorzugte Ausführungsformen der erfindungsgemäßen Beleuchtungseinheiten sind in den Figuren 3 bis 14 beschrieben.

In einer bevorzugten Ausführungsform der erfindungsgemäßen Beleuchtungseinheit handelt es sich bei der Lichtquelle um ein lumineszentes IndiumAluminiumGalliumNitrid, insbesondere der Formel InᵢGaⱼAlₖN, wobei 0 ≤ i, 0 ≤ j, 0 ≤ k, und i+j+k=1 ist.

Dem Fachmann sind mögliche Formen von derartigen Lichtquellen bekannt. Es kann sich hierbei um lichtemittierende LED-Chips unterschiedlichen Aufbaus handeln.

In einer weiteren bevorzugten Ausführungsform der erfindungsgemäßen Beleuchtungseinheit handelt es sich bei der Lichtquelle um eine lumineszente auf ZnO, TCO (Transparent conducting oxide), ZnSe oder SiC basierende Anordnung oder auch um eine auf einer organischen lichtemittierende Schicht basierende Anordnung (OLED).

In einer weiteren bevorzugten Ausführungsform der erfindungsgemäßen Beleuchtungseinheit handelt es sich bei der Lichtquelle um eine Quelle, die Elektrolumineszenz und/oder Photolumineszenz zeigt. Weiterhin kann es sich bei der Lichtquelle auch um eine Plasma- oder Entladungsquelle handeln.

Die erfindungsgemäßen Leuchtstoffe können entweder in einem Harz dispergiert (z.B. Epoxy- oder Siliconharz), oder bei geeigneten Größenverhältnissen direkt auf der primären Lichtquelle angeordnet werden oder aber von dieser, je nach Anwendung, entfernt angeordnet sein (letztere Anordnung schliesst auch die "Remote phosphor Technologie" mit ein). Die Vorteile der "Remote phosphor Technologie" sind dem Fachmann bekannt und z.B. der folgenden Publikation zu entnehmen: Japanese Journ. of Appl. Phys. Vol 44, No. 21 (2005). L649-L651.

In einer weiteren Ausführungsform ist es bevorzugt, wenn die optische Ankopplung der Beleuchtungseinheit zwischen dem Leuchtstoff und der primären Lichtquelle durch eine lichtleitende Anordnung realisiert wird. Dadurch ist es möglich, dass an einem zentralen Ort die primäre Lichtquelle installiert wird und diese mittels lichtleitender Vorrichtungen, wie beispielsweise lichtleitenden Fasern, an den Leuchtstoff optisch angekoppelt ist. Auf diese Weise lassen sich den Beleuchtungswünschen angepasste Leuchten lediglich bestehend aus einem oder unterschiedlichen Leuchtstoffen, die zu einem Leuchtschirm angeordnet sein können, und einem oder mehreren Lichtleitern, die an die primäre Lichtquelle angekoppelt ist, realisieren. Auf diese Weise ist es möglich, eine starke primäre Lichtquelle an einen für die elektrische Installation günstigen Ort zu platzieren und ohne weitere elektrische Verkabelung, sondern nur durch Verlegen von Lichtleitern an beliebigen Orten Leuchten aus Leuchtstoffen, welche an die Lichtleiter gekoppelt sind, zu installieren.

Weiterhin ist es erfindungsgemäß bevorzugt, wenn die primäre Lichtquelle, welche Licht im Vakuum-UV (< 200nm) und/oder UV emittiert, in Kombination mit dem erfindungsgemäßen Leuchtstoff eine Emissionsbande mit einer Halbwertsbreite von mindestens 10 nm aufweist.

Die erfindungsgemäßen Leuchtstoffekönnen teilweisen oder vollständigen Konversion der blauen oder im nahen UV-liegenden Emission einer Lumineszenzdiode verwendet werden.

Weiterhin bevorzugt ist die Verwendung der erfindungsgemäßen Leuchtstoffe zur Konversion der blauen oder im nahen UV-liegenden Emission in sichtbare weiße Strahlung. Weiterhin ist die Verwendung der erfindungsgemäßen Leuchtstoffe zur Konversion der Primärstrahlung in einen bestimmten Farbort nach dem "Color on demand"-Konzept bevorzugt.

Weiterhin können die erfindungsgemäßen Leuchtstoffe in Elektrolumineszenz-Materialien, wie beispielsweise Elektrolumineszenz-Folien (auch Leuchtfolien oder Lichtfolien genannt) verwendet werden in denen beispielsweise Zinksulfid oder Zinksulfid dotiert mit Mn²⁺, Cu⁺, oder Ag⁺ als Emitter eingesetzt wird, die im gelbgrünen Bereich emittieren. Die Anwendungsbereiche der Elektrolumineszenz-Folie sind z.B. Werbung, Displayhintergrundbeleuchtung in Flüssigkristallbildschirmen (LC-Displays) und Dünnschichttransistor-Displays (TFT-Displays), selbstleuchtende KFZ-Kennzeichenschilder, Bodengrafik (in Verbindung mit einem tritt- und rutschfesten Laminat), in Anzeigen- und/oder Bedienelementen beispielsweise in Automobilen, Zügen, Schiffen und Flugzeugen oder auch Haushalts-, Garten-, Mess- oder Sport- und Freizeitgeräten.

Die folgenden Beispiele sollen die vorliegende Erfindung verdeutlichen. Sie sind jedoch keinesfalls als limitierend zu betrachten. Alle Verbindungen oder Komponenten, die in den Zubereitungen verwendet werden können, sind entweder bekannt und käuflich erhältlich oder können nach bekannten Methoden synthetisiert werden. Die in den Beispielen angegebenen Temperaturen gelten immer in °C. Es versteht sich weiterhin von selbst, dass sich sowohl in der Beschreibung als auch in den Beispielen die zugegebenen Mengen der Komponenten in den Zusammensetzungen immer zu insgesamt 100% addieren. Gegebene Prozentangaben sind immer im gegebenen Zusammenhang zu sehen. Sie beziehen sich üblicherweise aber immer auf die Masse der angegebenen Teil- oder Gesamtmenge.

### Beispiele

### Beispiel 1: Herstellung des Leuchtstoffes Ba_{0.345}Sr_{1.6}Eu_{0.055}SiO₄ im Sprühtrockner

275,914 g Bariumhydroxid Octahydrat (Qualität reinst, Fa. Merck KGaA), 1062,480 g Strontiumhydroxid Octahydrat (Qualität reinst, Fa. Merck KGaA) sowie 50,369 g Europiumchlorid Hexahydrat (Qualität zur Analyse ACS, Fa. Treibacher Industrie AG) 150 werden in einem 20 I-Reaktor in 51 VE-Wasser mit einem KPG-Rührer suspendiert und auf 90 °C erhitzt. Nachdem das Material vollständig suspendiert ist, werden 150,0 g hochdisperses Siliciumdioxid (Qualität reinst Ph Eur,NF, E 551, Fa. Merck KGaA) zugegeben, hierfür wird mit ca. 5 I VE-Wasser nachgespült.
Die Reaktionslösung wird anschließend sprühgetrocknet.
Einstellungen Sprühturm (Fa. GEA Niro)
Düsendruck: 2 bar
Eingangstemperatur: 250 °C
Ausgangstemperatur: 68 bis 70 °C
Schlauchpumpe: 25 RPM (entspricht ca. 4 I/h)

Der Precursor aus Beispiel 1 wird dann in einem in reduzierender Formiergasatmosphäre stattfindenden Glühprozess bei 1200 °C in die Leuchtstoffe umgesetzt. Dazu wird der Precursor in einen 250 ml Korundtiegel gegeben, mit 1-10 wt%, in bevorzugter Ausführung mit 5 wt% Ammoniumchlorid unterschichtet, festgerüttelt und anschließend für 5 Stunden geglüht. Der fertige Leuchtstoffrohkuchen wird anschließend in einer Mcirsermühle gemahlen, danach gewaschen, getrocknet (T = 120 °C) und gesiebt.

### Beschreibung der Abbildungen

Im folgenden soll die Erfindung anhand mehrerer Ausführungsbeispiele näher erläutert werden. In den Fig. 3 bis 14 werden verschiedene Beleuchtungseinheiten beschrieben, die alle die erfindungsgemäßen Orthosilikatleuchtstoffe enthalten:

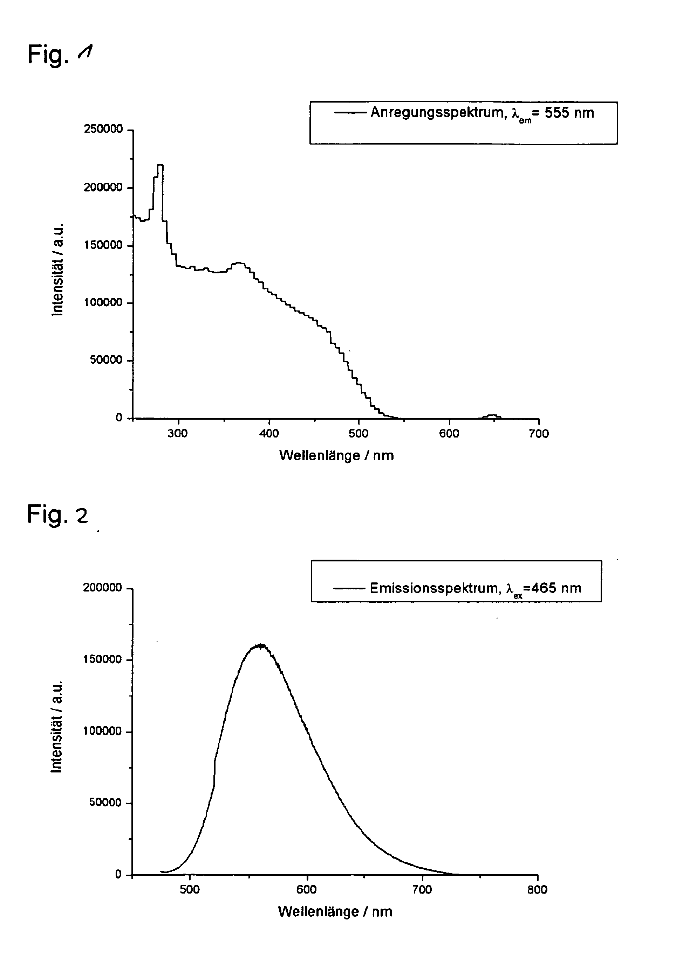

Fig. 1: Anregungsspektrum des Leuchstoffs **Ba**_{0.345}**Sr**_{1.6}**Eu**_{0.055}**SiO**₄
Fig. 2: Emissionspektrum des Leuchtstoffs **Ba**_{0.345}**Sr**_{1.6}**Eu**_{0.55}**SiO**₄ bei einer Anregung mit 465 nm.
Fig. 3: zeigt die schematische Abbildung einer Leuchtdiode mit einer Leuchtstoff-haltigen Beschichtung. Das Bauteil umfasst eine Chip-artige Leuchtdiode (LED) 1 als Strahlungsquelle. Die Licht emittierende Diode ist in einem becherförmigen Reflektor angebracht, der von einem Justagerahmen 2 gehalten wird. Der Chip 1 ist über ein Flachkabel 7 mit einem ersten Kontakt 6 und direkt mit einem zweiten elektrischen Kontakt 6' verbunden. Auf die innere Wölbung des Reflektorbechers wurde eine Beschichtung aufgebracht, die einen erfindungsgemäßen Konversionsleuchtstoff enthält. Die Leuchtstoffe werden entweder getrennt voneinander oder als Mischung eingesetzt. (Liste der Teilenummern: 1 Leuchtdiode, 2 Reflektor, 3 Harz, 4 Konversionsleuchtstoff, 5 Diffusor, 6 Elektroden, 7 Flachkabel)
Fig. 4: zeigt ein COB (Chip on board) Package des Typs InGaN, das als Lichtquelle (LED) für weißes Licht dient (1=Halbleiterchip; 2,3 = elektr.
Anschlüsse; 4 = Konversionsleuchtstoff; 7 = Board (Platine) Der Leuchtstoff ist in einer Bindemittellinse verteilt, die gleichzeitig ein sekundäres optisches Element darstellt und die Lichtabstrahlcharakteristik als Linse beeinflusst.

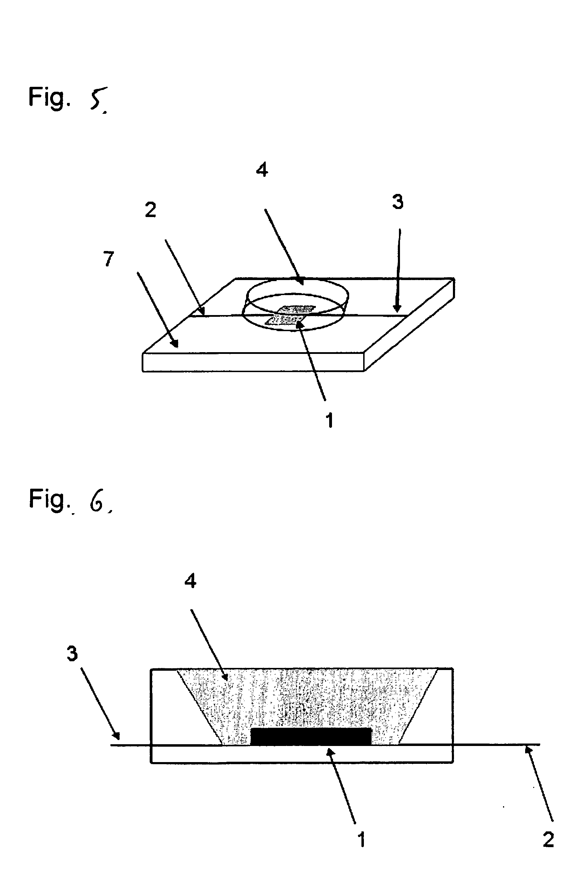

Fig. 5: zeigt ein COB (Chip on board) Package des Typs InGaN, das als Lichtquelle (LED) für weißes Licht dient (1=Halbleiterchip; 2,3 = elektr.
Anschlüsse; 4 = Konversionsleuchtstoff; 7 = Board (Platine) Der Leuchtstoff befindet sich in einer dünnen Bindemittelschicht verteilt direkt auf dem LED Chip. Ein sekundäres optisches Element bestehend aus einem transparenten Material kann darauf platziert werden.
Fig. 6: zeigt eine Art von Package, das als.Lichtquelle (LED) für weißes Licht dient (1 =Halbleiterchip; 2,3 = elektr. Anschlüsse; 4 = Konversionsleuchtstoff in Kavität mit Reflektor). Der Konversionsleuchtstoff befindet sich in einem Bindemittel dispergiert, wobei die Mischung die Kavität ausfüllt.

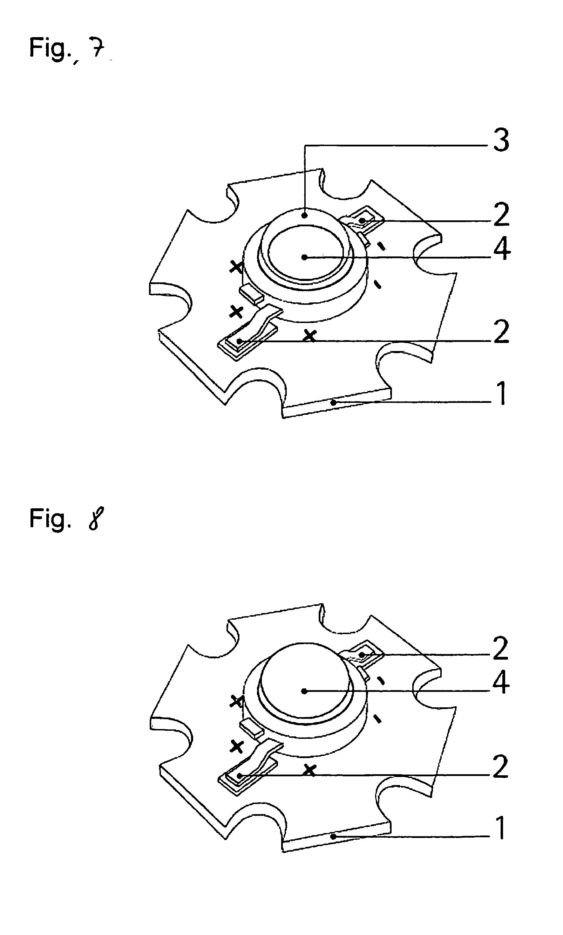

Fig. 7: zeigt eine zweite Art von Package, wobei 1= Gehäuseplatte; 2 = elektr. Anschlüsse; 3 = Linse; 4= Halbleiterchip bedeutet. Dieses Design hat den Vorteil, dass es sich um ein Flipchip-Design handelt, wobei über das transparente Substrat und einem Reflekor auf dem Boden ein größerer Anteil des Lichtes aus dem Chip für Lichtzwecke verwendet werden kann. Außerdem ist die Wärmeableitung bei diesem Design begünstigt.
Fig. 8: zeigt ein Package , wobei 1 = Gehäuseplatte; 2 = elektr. Anschlüsse; 4= Halbleiterchip bedeutet, und der Hohlraum unterhalb der Linse komplett mit dem erfindungsgemäßen Konversionsleuchtstoff ausgefüllt ist. Dieses Package hat den Vorteil, dass eine größere Menge Konversionsleuchtstoff verwendet werden kann. Dieser kann auch als Remote Phosphor wirken.

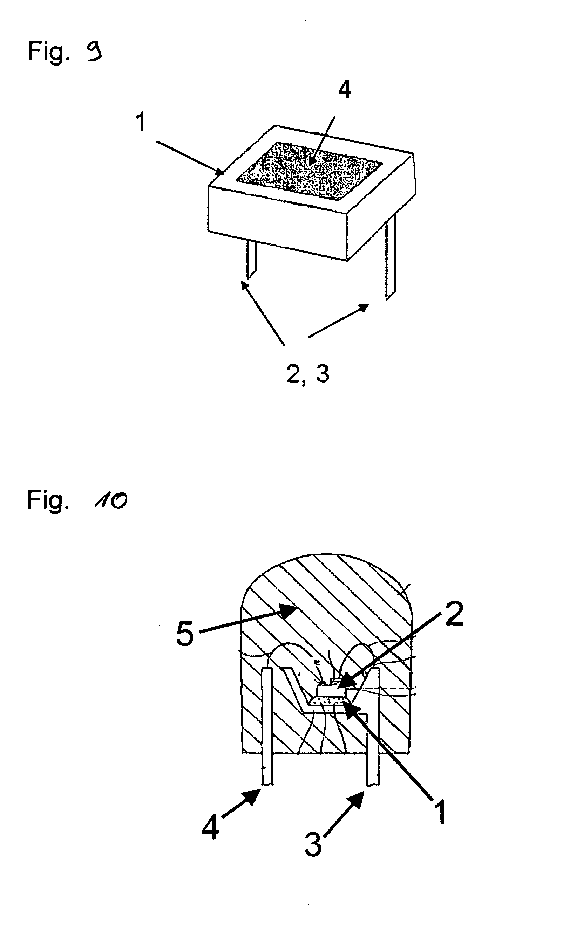

Fig. 9: zeigt ein SMD-Package (Surface mounted package) wobei 1= Gehäuse; 2, 3 = elektr. Anschlüsse, 4 = Konversionsschicht bedeutet. Der Halbleiterchip ist komplett mit dem erfindungsgemäßen Leuchtstoff bedeckt. Das SMD-Design hat den Vorteil, dass es eine kleine Bauform hat und somit in herkömmliche Leuchten passt.
Fig. 10: zeigt ein T5-Package, wobei 1= Konversionsleuchtstoff; 2 = Chip; 3,4 = elektr. Anschlüsse; 5 = Linse mit transparenten Harz bedeutet. Der Konversionsleuchtstoff befindet sich auf der Rückseite des LED-Chips, was den Vorteil hat, dass der Leuchtstoff über die metallischen Anschlüsse gekühlt wird.

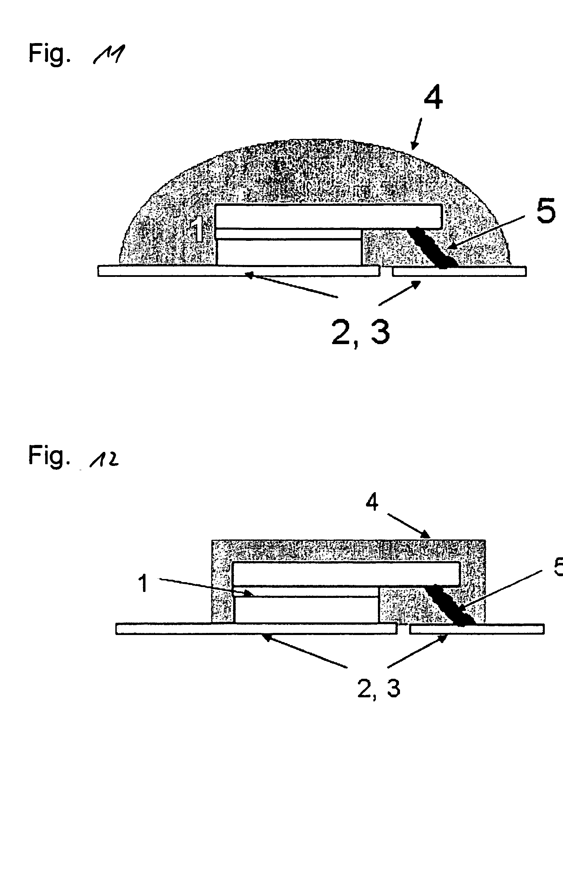

Fig. 11: zeigt eine schematische Abbildung einer Leuchtdiode mit 1= Halbleiterchip; 2,3 = elektr. Anschlüsse; 4 =Konversionsleuchtstoff, 5 = Bonddraht, wobei der Leuchtstoff in einem Bindemittel als Top Globe aufgebracht ist. Diese Form der Leuchtstoff-/Bindemittelschicht kann als sekundäres optisches Element wirken und z. B. die Lichtausbreitung beeinflussen.
Fig. 12: zeigt eine schematische Abbildung einer Leuchtdiode mit 1= Halbleiterchip; 2,3 = elektr. Anschlüsse; 4 =Konversionsleuchtstoff, 5 = Bonddraht, wobei der Leuchtstoff als dünne Schicht in einem Bindemittel dispergiert aufgebracht ist. Auf diese Schicht lässt sich leicht ein weiteres, als sekundäres optisches Element wirkendes Bauteil, wie z.B eine Linse aufbringen.

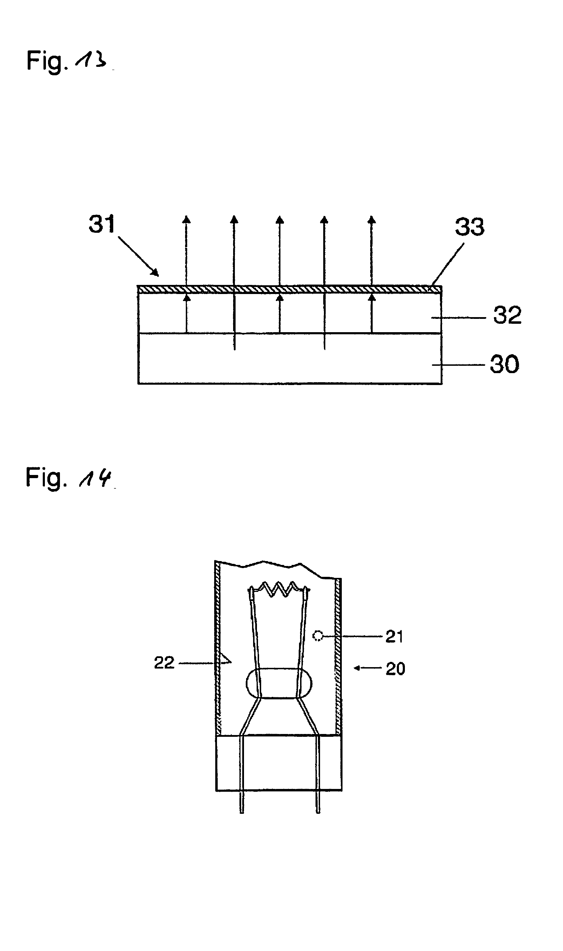

Fig. 13: zeigt ein Beispiel für eine weitere Anwendung, wie sie im Prinzip bereits aus US-B 6,700,322 bekannt ist. Dabei wird der erfindungsgemäße Leuchtstoff zusammen mit einer OLED angewendet. Die Lichtquelle ist eine organisch lichtemittierende Diode 31, bestehend aus der eigentlichen organischen Folie 30 und einem transparenten Substrat 32. Die Folie 30 emittiert insbesondere blaues primäres Licht, erzeugt beispielsweise mittels PVK:PBD:Kumarin (**PVK**, Abk. für poly(n-vinylcarbazol); **PBD**, Abk. für 2-(4-biphenyl)-5-(4-tert.-butylphenyl)-1,3,4-oxadiazol)). Die Emission wird von einer Deckschicht, gebildet aus einer Schicht 33 des erfindungsgemäßen Leuchtstoffs, teilweise in gelbes, sekundär emittiertes Licht umgewandelt, so dass insgesamt durch Farbmischung des primär und sekundär emittierten Lichts eine weiße Emission realisiert wird. Die OLED besteht im wesentlichen aus mindestens einer Schicht eines lichtemittierenden Polymers oder von sog. small molecules zwischen zwei Elektroden, die aus an sich bekannten Materialien bestehen, wie bespielsweise ITO (Abk. für "indium tin oxide") als Anode und ein hochreaktives Metall, wie z.B. Ba oder Ca, als Kathode. Oft werden auch mehrere Schichten zwischen den Elektroden verwendet, die entweder als Lochtransportschicht dienen oder im Bereich der small molecules auch als Elektronentransportschichten dienen. Als emittierende Polymere kommen beispielsweise Polyfluorene oder Polyspiro-Materialien zum Einsatz.
Fig. 14: zeigt eine Niederdrucklampe 20 mit einer quecksilberfreien Gasfüllung 21 (schematisiert), die eine Indium-Füllung und ein Puffergas analog WO 2005/061659 enthält, wobei eine Schicht 22 aus den erfindungsgemäßen Leuchtstoffen angebracht ist.

## Patentansprüche

1. Verfahren zur Herstellung eines Leuchtstoffes der Formel I
Ba_{w}SrₓCa_{y}SiO₄: zEu²⁺ (I)
wobei
w+x+y+z=2
0,005 < z < 0,5 gilt,
**dadurch gekennzeichnet, dass**
a) mindestens zwei Erdalkalihydroxide sowie ein Europium-haltiger Dotierstoff in Form von Chloriden oder deren Gemische in Wasser, Säuren oder Basen gelöst, suspendiert oder dispergiert werden und
b) eine Silicium-haltige Verbindung bei einer Temperatur zwischen 75°C und 90°C zugesetzt und
c) dieses Gemisch bei Temperaturen < 300°C sprühgetrocknet wird und
d) anschließend durch thermische Nachbehandlung zu fertigen Leuchtstoffen umgewandelt wird.

2. Verfahren nach Anspruch 1, **dadurch gekennzeichnet, dass** vor oder während der thermischen Nachbehandlung ein anorganisches Salz als Flussmittel zugesetzt wird.

3. Verfahren nach Anspruch 2, **dadurch gekennzeichnet, dass** als anorganisches Salz, welches sich in einer exothermen Reaktion zersetzt, ausgewählt aus der Gruppe Chlorid, vorzugsweise Ammoniumchlorid, oder Nitrat oder Chlorat in einer Menge von 0,5 bis 80%, vorzugsweise 1 bis 5%, bezogen auf die eingesetzte Edukt-Menge zugesetzt wird.

4. Verfahren nach einem oder mehreren der Ansprüche 1 bis 3, **dadurch gekennzeichnet, dass** die Oberfläche des Leuchtstoffes zusätzlich mit einer geschlossenen Beschichtung aus SiO₂, TiO₂, Al₂O₃, ZnO, ZrO₂ und/oder Y₂O₃ oder Mischoxide daraus versehen wird.

5. Verfahren nach einem oder mehreren der Ansprüche 1 bis 3, **dadurch gekennzeichnet, dass** die Oberfläche des Leuchtstoffes mit einer porösen Beschichtung aus SiO₂, TiO₂, Al₂O₃, ZnO, ZrO₂ und/oder Y₂O₃ oder Mischoxide daraus oder aus der Leuchtstoffzusammensetzung versehen wird.

6. Verfahren nach einem oder mehreren der Ansprüche 1 bis 5, **dadurch gekennzeichnet, dass** die Oberfläche zusätzlich mit funktionellen Gruppen versehen wird, welche eine chemische Anbindung an die Umgebung, vorzugsweise aus Epoxy- oder Silikon harz, ermöglichen.

## Claims

1. Process for the preparation of a phosphor of the formula I
Ba_{w}SrₓCa_{y}SiO₄: zEu²⁺ (I)
where
w+x+y+z=2,
0.005 < z < 0.5,
**characterised in that**
a) at least two alkaline-earth metal hydroxides and a europium-containing dopant in the form of chlorides or mixtures thereof are dissolved, suspended or dispersed in water, acids or bases and
b) a silicon-containing compound is added at a temperature between 75°C and 90°C and
c) this mixture is spray-dried at temperatures < 300°C and
d) subsequently converted into finished phosphors by thermal aftertreatment.

2. Process according to Claim 1, **characterised in that** an inorganic salt is added as fluxing agent before or during the thermal aftertreatment.

3. Process according to Claim 2, **characterised in that** the inorganic salt which decomposes in an exothermic reaction, selected from the group chloride, preferably ammonium chloride, or nitrate or chlorate, is added in an amount of 0.5 to 80%, preferably 1 to 5%, based on the amount of starting material employed.

4. Process according to one or more of Claims 1 to 3, **characterised in that** the surface of the phosphor is additionally provided with a continuous coating of SiO₂, TiO₂, Al₂O₃, ZnO, ZrO₂ and/or Y₂O₃ or mixed oxides thereof.

5. Process according to one or more of Claims 1 to 3, **characterised in that** the surface of the phosphor is provided with a porous coating of SiO₂, TiO₂, Al₂O₃, ZnO, ZrO₂ and/or Y₂O₃ or mixed oxides thereof or of the phosphor composition.

6. Process according to one or more of Claims 1 to 5, **characterised in that** the surface is additionally provided with functional groups which facilitate chemical bonding to the environment, preferably consisting of epoxy or silicone resin.

## Revendications

1. Procédé de préparation d'un luminophore de formule I
Ba_{w}SrₓCa_{y}SiO₄: zEu²⁺ (I)
dans laquelle
w+x+y+z=2,
0,005 < z < 0,5,
**caractérisé en ce que**
a) au moins deux hydroxydes de métaux alcalino-terreux et un dopant contenant de l'europium sous la forme de chlorures ou de mélanges de ceux-ci sont solubilisés, mis en suspension ou dispersés dans de l'eau, des acides ou des bases et
b) un composé contenant du silicium est ajouté à une température comprise entre 75°C et 90°C et
c) ce mélange est séché par pulvérisation à des températures < 300°C et
d) est ensuite converti en luminophores finis par post-traitement thermique.

2. Procédé selon la revendication 1, **caractérisé en ce qu'**un sel inorganique est ajouté comme fondant avant ou après le post-traitement thermique.

3. Procédé selon la revendication 2, **caractérisé en ce que** le sel inorganique qui se décompose dans une réaction exothermique, choisi dans le groupe constitué par le chlorure, préférablement le chlorure d'ammonium, ou le nitrate ou le chlorate, est ajouté en une quantité allant de 0,5 à 80%, préférablement de 1 à 5%, sur la base de matériau de départ employé.

4. Procédé selon l'une ou plusieurs parmi les revendications 1 à 3, **caractérisé en ce que** la surface du luminophore est en outre pourvue d'un revêtement continu de SiO₂, TiO₂, Al₂O₃, ZnO, ZrO₂ et/ou Y₂O₃ ou d'oxydes mixtes de ceux-ci.

5. Procédé selon l'une ou plusieurs parmi les revendications 1 à 3, **caractérisé en ce que** la surface du luminophore est pourvue d'un revêtement poreux de SiO₂, TiO₂, Al₂O₃, ZnO, ZrO₂ et/ou Y₂O₃ ou d'oxydes mixtes de ceux-ci ou de la composition de luminophore.

6. Procédé selon l'une ou plusieurs parmi les revendications 1 à 5, **caractérisé en ce que** la surface est en outre pourvue de groupements fonctionnels qui facilitent une liaison chimique avec l'environnement, constitué de préférence de résine époxy ou de silicone.
